# EUROPEAN PATENT SPECIFICATION

(11) **EP 1 892 459 B1**
(45) Date of publication and mention of the grant of the patent: **30.06.2010**
(21) Application number: 06731034.2
(22) Date of filing: 04.04.2006
(51) Int. Cl.: F21S 2/00, F21V 5/04, H01L 33/00, B60K 35/00, G02B 27/01, G02F 1/13357, B60R 11/02, F21Y 101/02

(54) **Lighting device for a liquid crystal display device**
Beleuchtungsvorrichtung für eine Flüssigkristallanzeigevorrichtung
Dispositif d'eclairage pour un dispositif d affichage a cristaux liquides

(30) Priority: 26.04.2005 JP 2005127874
(43) Date of publication of application: 27.02.2008
(73) Proprietor: NIPPON SEIKI CO., LTD., Nagaoka-shi, Niigata 940-8580 (JP)
(72) Inventor: YAMAZOE, Takashi, Nigata 940 (JP); NAGANO, Keiichi, Nigata 940 (JP); TAKAHASHI, Yuichi, Nigata 940 (JP)
(74) Representative: Jackson, Richard Eric
(86) International application number: PCT/JP2006/307086
(87) International publication number: WO 2006/117960

(56) References cited:
- JP-A- 2000 261 034
- JP-A- 2001 135 121
- JP-A- 2003 110 146

## Description

The present invention relates to an illuminating device and liquid-crystal display panel having light-emitting elements, such as light-emitting diodes, and to a liquid-crystal display apparatus having illumination means for illuminating the liquid-crystal panel transmissively.

### BACKGROUND OF THE INVENTION

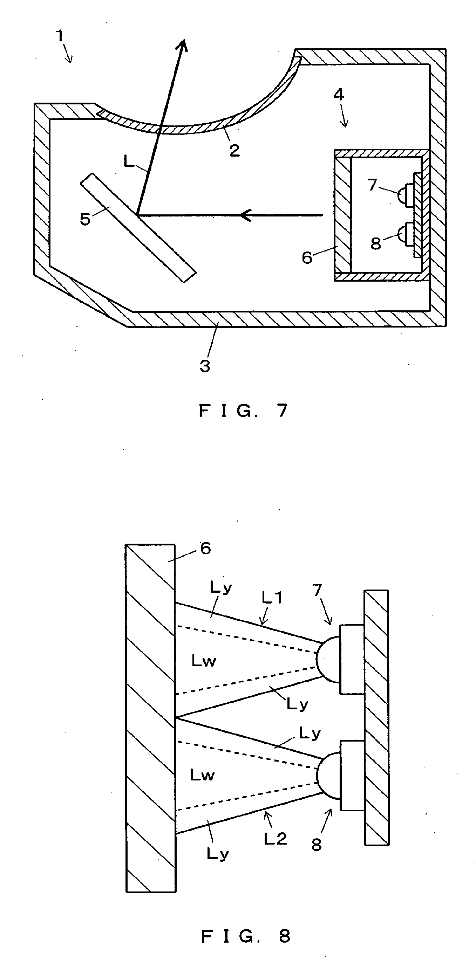

Traditionally, a variety of vehicular head-up displays, using liquid-crystal display apparatuses, have been proposed and disclosed in Patent Document 1, for example. Such a vehicular head-up display 1 is to project display light L onto a vehicular front glass or a translucent plate called combiner and display a virtual image. A vehicular head-up display 1 contains a liquid-crystal display apparatus 4 and a reflection mirror 5, in a housing 3 having a light-transmissive window 2. The display light L, emitted by the liquid-crystal display apparatus 4, is reflected by the reflection mirror 5 and projected onto the front glass or the translucent plate (see Fig. 7).
Patent Document 1: Japanese Unexamined Patent Application No. 2003-295105

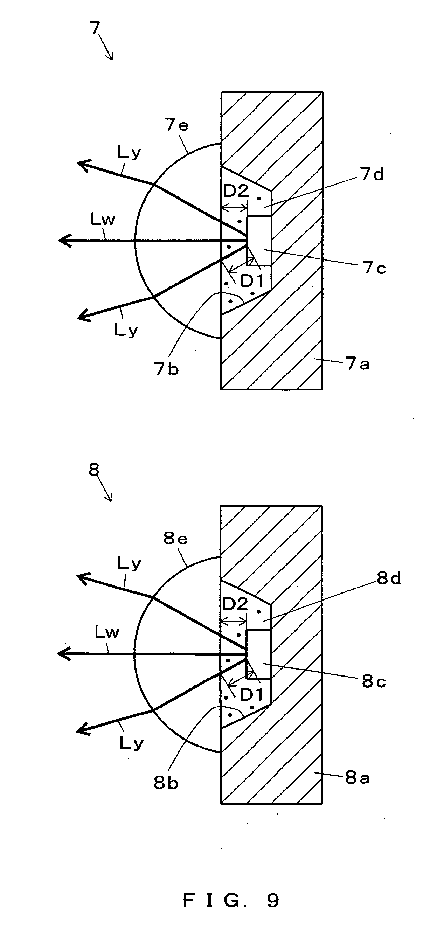

The liquid-crystal display apparatus 4 has a liquid-crystal display panel 6 and light-emitting elements 7, 8, such as light-emitting diodes, that illuminates the liquid-crystal panel 6 transmissively. The light-emitting elements 7, 8 each have a base 7a, 8a, a light-emitting diode chip 7c, 8c provided in a recess 7b, 8b formed in the base 7a, 8a, a fluorescent material 7d, 8d such as of YAG (Yttrium Aluminum Garnet) for wavelength-converting the light emitted by the light-emitting diode chip 7c, 8c, and a lens 7e, 8e formed of a light-transmissive resin in a generally semispherical form (see Fig. 9). The light-emitting diode chip 7c, 8c is to emit blue light while the fluorescent material 7d, 8d is to convert part of the light emitted from the light-emitting diode chip 7c, 8c into yellow, a complementary color of blue. The beams of illumination light L1, L2, emitted by the light-emitting elements 7, 8, are mixed with the blue emitted by the light-emitting diodes chip 7c, 8c and with the yellow converted by the fluorescent materials 7d, 8d, thus being turned into generally white in color.

Japanese patent application nos. 2001-135121 and 2000-261034 both discuss light-transmissive optical members.

### DISCLOSURE OF THE INVENTION

### PROBLEM THAT THE INVENTION IS TO SOLVE

However, the beams of illumination light L1, L2, emitted by the light-emitting diodes 7, 8, have a light portion Lw white in color at a center whereas a light portion Ly obliquely emitted by the light-emitting diodes 7, 8 is somewhat yellowish. Thus, there is involved a problem that color irregularity occurs on the liquid-crystal display panel 6 being illuminated transmissively with the beams of illumination light L1, L2. This problem can be considered because of the reason that the beams of light, emitted by the light-emitting diode chips 7c, 8c, are different in passage length through the fluorescent materials 7d, 8d depending upon the direction of illumination. Namely, the passage length D1, the light obliquely emitted from the light-emitting diode chips 7c, 8c passes through the fluorescent materials 7d, 8d, is greater than the length D2 the light emitted nearly parallel with the optical axis passes through the fluorescent material 7d. Thus, the obliquely emitted portion of light is in a color somewhat yellowish.
The present invention has been made in view of the problem and is to provide an illuminating device that possibly causes less irregularity of color.

### MEANS FOR SOLVING THE PROBLEM

The present invention comprises, as described in claim 1, a first light-emitting element 23 for emitting a first illuminating light L1, a second light-emitting element 24 provided juxtaposed with the first light-emitting element 23 and for emitting a second illuminating light L2, and an optical member 26 formed of a light-transmissive material and having a first slant surface 26a for refracting the first beam of illumination light L1 and a second slant surface 26b for refracting the second beam of illumination light L2 in a manner overlapping part of the first beam of illumination light L1 and part of the second beam of illumination light L2 together. The optical member 26 has a first incident surface 26a formed by the first slant surface on which the first beam of illumination light L1 is to be incident, a first exit surface 26c formed by a convex lens surface through which the first beam of illumination light L1 is to exit, a second incident surface 26b formed by the second slant surface on which the second beam of illumination light L2 is to be incident and a second exit surface 26d, 55d formed by a convex lens surface through which the second beam of illumination light L2 is to exit.

Meanwhile, in the invention, the first light-emitting element 23 and the second light-emitting element 24 each have a light-emitting diode chip 23c, 24c and a fluorescent body 23d, 24d for wavelength-converting the beam of light emitted by the light-emitting diode chip 23c, 24c, as described in claim 2.

Meanwhile, in the invention, a circuit board 25 is provided which is mounted with a plurality of the first light-emitting elements 23 and a plurality of the second light-emitting elements 24, as described in claim 3.

### EFFECT OF THE INVENTION

By overlapping part of the first beam of illumination light emitted from the first light-emitting element and part of the second beam of illumination light emitted from the second light-emitting element together, the possibility of color irregularity occurrence can be reduced.

### BRIEF DESCRIPTION OF THE DRAWINGS

[Fig. 1] A sectional view showing an embodiment of the present invention.
[Fig. 2] An overview of a head-up display showing the embodiment.
[Fig. 3] A magnifying sectional view of illuminating means showing the embodiment.
[Fig. 4] A front view of a circuit board showing the embodiment.
[Fig. 5] A sectional view of illuminating means showing the embodiment.
[Fig. 6] A sectional view showing an example.
[Fig. 7] A sectional view showing a prior art.
[Fig. 8] A magnifying sectional view of a light-emitting diode showing the prior art.
[Fig. 9] A sectional view showing the prior art.

### DESCRIPTION OF REFERENCE NUMERALS AND SIGNS

- 19: Liquid-crystal display panel
- 21: Illuminating means
- 23: Light-emitting diode (first light-emitting element)
- 23c: Light-emitting diode chip
- 23d: Fluorescent material
- 24c: Light-emitting diode chip
- 24d: Fluorescent material
- 25: Circuit board
- 26: Optical member
- 26a: First slant surface (first incident surface)
- 26b: Second slant surface (second incident surface)
- 26c: Convex lens surface (first exit surface)
- 26d: Convex lens surface (second exit surface)
- 55c: Convex lens surface (first exit surface)
- 55d: Convex lens surface (second exit surface)
- 56: Optical member
- 56a: First slant surface (first incident surface)
- 56b: Second slant surface (second incident surface)
- L1: First beam of illumination light
- L2: Second beam of illumination light

### BEST MODE FOR CARRYING OUT OF THE INVENTION

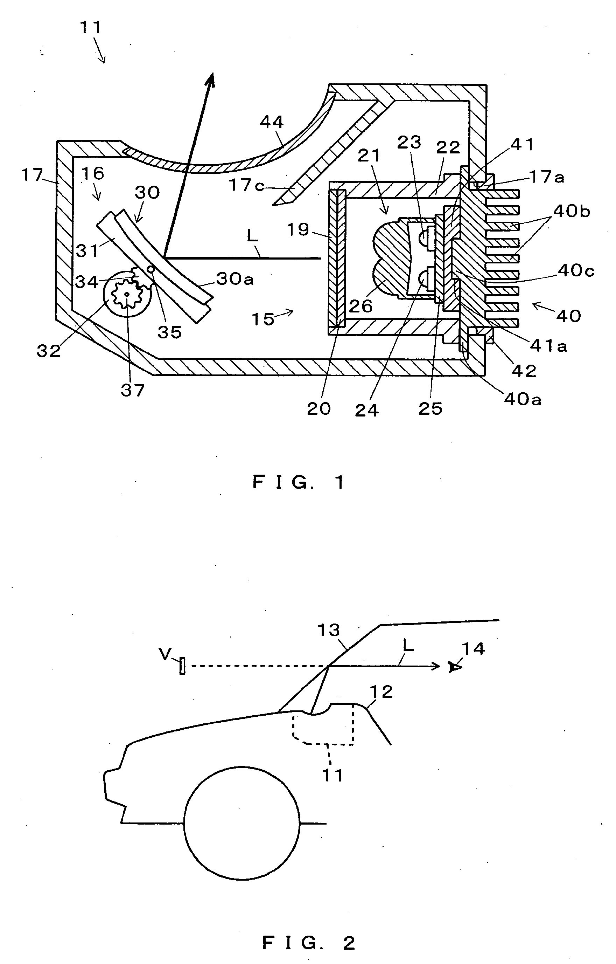

Based on the attached drawings, explanation will be made below on one embodiment the invention is applied to a head-up display. Figs. 1 to 5 show the embodiment.

A head-up display 11 is arranged in a dashboard 12 of a vehicle (see Fig. 2). The display light L, projected by the head-up display 11, is reflected by a front glass 13 toward an observer 14. The observer 14 is allowed to view a virtual image V superposed on a scene.

The head-up display 11 contains a liquid-crystal display apparatus 15 and a reflector 16 in its housing 17. The liquid-crystal display apparatus 15 has a liquid-crystal display panel 19, a light-diffusion plate 20, illumination means 21 and a case 22.
The liquid-crystal display panel 19 is bonded with polarizer films at front and rear surfaces of a liquid-crystal cell that a liquid crystal is filled between a pair of glass substrates formed with transparent electrodes, thus being fixed on the case 22. The light diffusion plate 20 is arranged on a backside of the liquid-crystal display panel 19 and fixed on the case 22.

The illumination means 21 has a light-emitting diode 23 (first light-emitting element), a light-emitting diode 24 (second light-emitting element), a circuit board 25 and an optical element 26. The illumination means 21 is arranged in back of the liquid-crystal display panel 19 and for illuminating the liquid-crystal display panel 19 transmissively.
The case 22 is formed in a nearly rectangularly cylindrical form so that the liquid-crystal display panel 19 and the light diffusion plate 20 are held at the front end of the case 21. The case 22 has a rear end fixed on a heat sink member, referred later.

The reflector 16 has a concave mirror 30, a support member 31 and a stepping motor 32. The concave mirror 30 has a reflection surface 30a formed by evaporating a metal (e.g. aluminum) over a resin (e.g. polycarbonate). The reflection surface 30a is made as a concave surface so that a virtual image V can be displayed by enlarging the display light L caused by the liquid-crystal display apparatus 15. The concave mirror 30 is bonded on the support member 31 by means of a double-sided adhesive tape. The support member 31 is formed of a resin (e.g. ABS) and integral with a gear 34 and a shaft 35. The shaft 35 of the support member 31 is pivotally supported by the housing 17.

A gear 37 is attached on the rotary shaft of the stepping motor 32. The gear 37 is in mesh with the gear 34 of the support member 31. The concave mirror 30 is supported rotatably together with the support member 31. The stepping motor 32 can rotate the concave mirror 30, to adjust the projecting direction of display light L. The observer 14 is to operate a push button switch (not shown) and adjust the angle of the concave mirror 30 so that display light L can be reflected to the position of the eye (i.e. so that a virtual image V can be visually perceived).

40 is a heat sink member, which heat sink member 40 is arranged in an opening 17a of the housing 17. The heat sink member 40 at its flange 40a is fixed on the housing 17 by means of not-shown screws. The heat sink member 40 is for releasing the heat of the light-emitting diodes 23, 24 to the outside of the housing 17 through a heat conductive sheet 41 formed of an elastic body, such as of silicone rubber. The heat sink member 40 has a multiplicity of plate-like fins 40b. The heat sink member 40 is formed with a convex 40c in a rectangular parallelepiped form. The heat conductive sheet 41 has a concave 41a corresponding to the convex 40c of the heat sink member 40, thus increasing the contact area of between the heat conductive sheet 41 and the heat sink member 40. 42 is a packing member in a rectangular annular form, which packing member 42 closes between the heat sink member 40 and the opening 17a of the housing 17, thereby preventing the intrusion of dust into the housing 17.

The housing 17 accommodates therein the liquid-crystal display apparatus 15 and the reflector 16. The housing 17 is provided with a window 44 allowing display light L to exit. The window 44 is formed of a light-transmissive resin (e.g. acryl) and made in a curved form. The housing 17 is provided with a light-shield wall 17c, thus preventing the phenomenon (washout) that ambient light, such as solar light, enters the liquid-crystal display apparatus 15 and makes it not easy to view the virtual image V. The light-shield wall 17c is in a plate form and formed obliquely extending downwardly from the upper part of the housing 17.

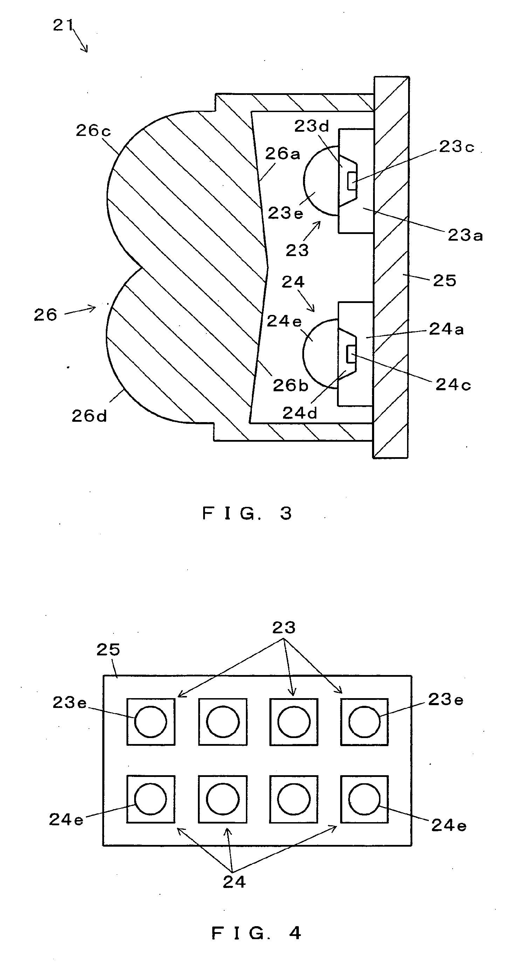

Next, description is made in detail on the illumination means 21 having the light-emitting diodes 23, 24, the circuit board 25 and the optical member 26.
As shown in Fig. 3, the light-emitting diodes 23, 24 each have a base 23a, 24a, a light-emitting diode chip 23c, 24c, a yellow fluorescent material 23d, 24d for waveform-converting the light emitted from the light-emitting diode chip 23c, 24c, and a lens made of a light-transmissive resin. The light-emitting diode chip 23c, 24c are to emit blue light while the fluorescent material 23d, 24d is to convert part of the light emitted by the light-emitting diode chip 23c, 24c into yellow. The beams of illumination light L1, L2 emitted from the light-emitted diodes 23, 24, are immixed with the blue emitted by the light-emitting diode chip 23c, 24c and with the yellow converted by the fluorescent material 23d, 24d, thus being changed into nearly white in color. The light-emitting diodes 23, 24 are juxtaposed four on each (totally eight) on the circuit board 24 (see Fig. 4). On the circuit board 25, a wiring pattern (not shown) is provided to supply power to the light-emitting diodes 23, 24.

The optical member 26, formed of a light-transmissive resin such as polycarbonate, has a first slant surface 26a upon which is to be incident the first beam of illumination light L1 emitted by the light-emitting diode 23, a second slant surface 26b upon which is to be incident the second beam of illumination light L2 emitted by the light-emitting diode 24, a convex lens surface 26c allowing the first beam of illumination light L1 to exit, and a convex lens surface 26d allowing the second beam of illumination light L2 to exit. The first and second slant surfaces 26a, 26b of the optical member 26, are finished as flat surfaces while the convex lens surfaces 26c, 26d are as spherical surfaces.

The first beam of illumination light L1, emitted by the light-emitting diode 23, is refracted at the first slant surface 26a and incident upon the optical member 26, and further refracted at the convex lens 26c and allowed to exit from the optical member 26, thus illuminated to the liquid-crystal display panel 19.
The second beam of illumination light L2, emitted by the light-emitting diode 24, is refracted at the second slant surface 26b and incident upon the optical member 26, and further refracted at the convex lens 26d and allowed to exit from the optical member 26, thus illuminated Lo the liquid-crystal display panel 19.

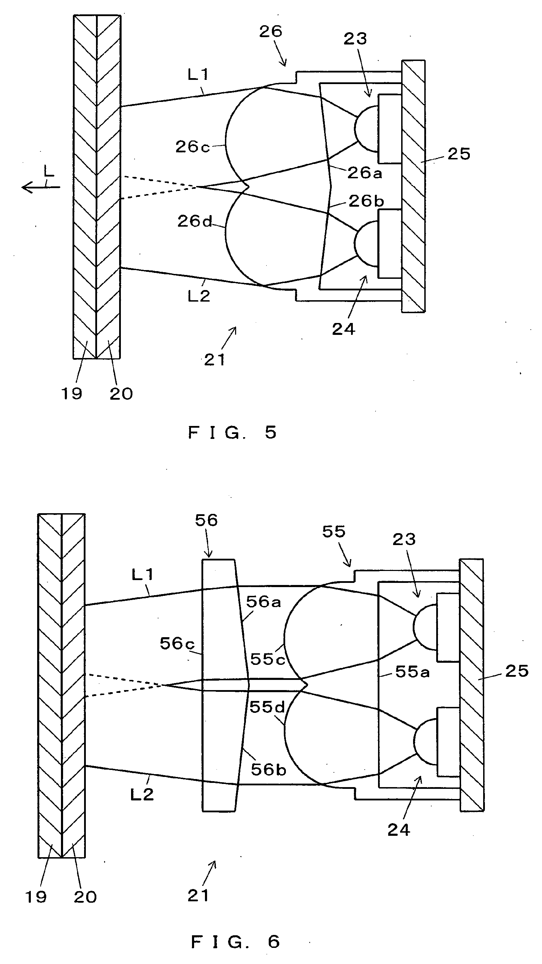

Fig. 6 shows an example wich is not part of the claimed invention. It is different only in respect of its optical members 55, 56 wherein the other structures are similar to the embodiment.
The optical member 55 is formed of a light-transmissive resin, such as polycarbonate. This has an incident surface 55a upon which are to be incident the first beam of illumination light L1 and the second beam of illumination light L2 that are emitted by the light-emitting diodes 23, 24, a convex lens surface 55c through which the first beam of illumination light L1 is to exit, and a convex lens surface 55d through which the second beam of illumination light L2 is to exit.

The optical member 56 is formed of a light-transmissive resin, such as polycarbonate. This has a first slant surface 56a upon which the first beam of illumination light L1 exited from the convex lens surface 55c is to be incident, a second slant surface 56b upon which the second beam of illumination light L2 exited from the convex lens surface 55d is to be incident, and an exit surface 56c through which the first beam of illumination light L1 and second beam of illumination light L2 is to exit.

The first beam of illumination light L1, emitted by the light-emitting diode 23, is refracted at the incident surface 55a, the convex lens surface 55c and the first slant surface 56a, and allowed to exit through the exit surface 56c and illuminated to the liquid-crystal display panel 19.
The second beam of illumination light L2, emitted by the light-emitting diode 24, is refracted at the incident surface 55a, the convex lens surface 55d and the second slant surface 56b, and allowed to exit through the exit surface 56c and illuminated to the liquid-crystal display panel 19.

According to the embodiment and the example, the first beam of illumination light L1 and the second beam of illumination light L2, that are obliquely illuminated by the light-emitting diodes 23, 24, are partly in a color somewhat yellowish but is less in color irregularity because those overlap with white portions of the second and first illumination light L2, L1 that are illuminated nearly parallel with the optical axis by the light-emitting diodes 24, 23.

### INDUSTRIAL APPLICABILITY

The present invention is applicable to a liquid-crystal display apparatus having illumination means for illuminating a liquid-crystal display panel transmissively.

## Claims

1. An illuminating device comprising:
a first light-emitting element (23) for emitting a first beam of illumination light (L1);
a second light-emitting element (24) provided juxtaposed with the first light-emitting element and for emitting a second beam of illumination light (L2); and
an optical member (26) formed of a light-transmissive material and having a first slant surface (26a) for refracting the first beam of illumination light and a second slant surface (26b) for refracting the second beam of illumination light in a manner overlapping part of the first beam of illumination light and part of the second beam of illumination light together;
wherein the optical member (26a) has a first incident surface (26a) formed by the first slant surface on which the first beam of illumination light (L1) is to be incident, and a second incident surface (26b) formed by the second slant surface on which the second beam of illumination light (L2) is to be incident,
**characterised in that** the optical member (26a) further has a first exit surface (26c) formed by a convex lens surface through which the first beam of illumination light (L1) is to exit, and a second exit surface (26d) formed by a convex lens surface through which the second beam of illumination light (L2) is to exit.

2. An illuminating device according to claim 1, wherein the first light-emitting element and the second light-emitting element each have a light-emitting diode chip (23c, 24c) and a fluorescent material (23d, 24d) for wavelength-converting the beam of light emitted by the light-emitting diode chip.

3. An illuminating device according to claim 1, wherein a circuit board (25) is provided which is mounted with a plurality of the first light-emitting elements (23) and a plurality of the second light-emitting elements (24).

## Patentansprüche

1. Beleuchtungsvorrichtung, umfassend:
ein erstes Lichtaussendeelement (23) zum Aussenden eines ersten Beleuchtungslichtstrahles (L1);
ein benachbart zu dem ersten Lichtaussendeelement vorgesehenes zweites Lichtaussendeelement (24) zum Aussenden eines zweiten Beleuchtungslichtstrahles (L2); und
ein von einem lichtdurchlässigen Material gebildetes optisches Element (26) mit einer ersten schrägen Oberfläche (26a) zum Brechen des ersten Beleuchtungslichtstrahles und einer zweiten schrägen Oberfläche (26b) zum Brechen des zweiten Beleuchtungslichtstrahles auf eine Weise, bei der ein Teil des ersten Beleuchtungslichtstrahles und ein Teil des zweiten Beleuchtungslichtstrahles miteinander überlappen;
wobei das optische Element (26a) eine erste Einfallsoberfläche (26a), die von der ersten schrägen Oberfläche gebildet wird, an der der erste Beleuchtungslichtstrahl (L1) einfallen soll, und eine zweite Einfallsoberfläche (26b), die von der zweiten schrägen Oberfläche gebildet wird, an der der zweite Beleuchtungslichtstrahl (L2) einfallen soll, aufweist,
**dadurch gekennzeichnet, dass** das optische Element (26a) des Weiteren eine erste Austrittsoberfläche (26c), die von einer konvexen Linsenoberfläche gebildet wird, durch die der erste Beleuchtungslichtstrahl (L1) austreten soll, und eine zweite Austrittsoberfläche (26d), die von einer konvexen Linsenoberfläche gebildet wird, durch die der zweite Beleuchtungslichtstrahl (L2) austreten soll, aufweist.

2. Beleuchtungsvorrichtung nach Anspruch 1, wobei das erste Lichtaussendeelement und das zweite Lichtaussendeelement jeweils einen Lichtaussendediodenchip (23c, 24c) und ein fluoreszentes Material (23d, 24d) zur Wellenlängenumwandlung des von dem Lichtaussendediodenchip ausgesandten Lichtstrahles aufweisen.

3. Beleuchtungsvorrichtung nach Anspruch 1, wobei eine Leiterplatte (25) vorgesehen ist, die mit einer Mehrzahl der ersten Lichtaussendeelemente (23) und einer Mehrzahl der zweiten Lichtaussendeelemente (24) montiert ist.

## Revendications

1. Dispositif d'éclairage comprenant :
un premier élément électro-luminescent (23) pour émettre un premier faisceau de lumière d'éclairage (L1);
un second élément électro-luminescent (24) juxtaposé au premier élément électro-luminescent et destiné à émettre un second faisceau de lumière d'éclairage (L2); et
un élément optique (26) constitué d'un matériau transmettant la lumière et présentant une première surface inclinée (26a) pour réfracter le premier faisceau de lumière d'éclairage et une seconde surface inclinée (26b) pour réfracter le second faisceau de lumière d'éclairage de manière telle qu'une partie du premier faisceau de lumière d'éclairage et une partie du second faisceau de lumière d'éclairage se chevauchent mutuellement;
l'élément optique (26a) présentant une première surface incidente (26a) formée par la première surface inclinée sur laquelle doit être incident le premier faisceau de lumière d'éclairage (L1), et une seconde surface incidente (26b) formée par la seconde surface inclinée sur laquelle doit être incident le second faisceau de lumière d'éclairage (L2),
***caractérisé en ce que*** l'élément optique (26a) présente, en outre, une première surface de sortie (26c) formée par une surface de lentille convexe à travers laquelle doit sortir le premier faisceau de lumière d'éclairage (L1), et une seconde surface de sortie (26d) formée par une surface de lentille convexe à travers laquelle doit sortir le second faisceau de lumière d'éclairage (L2).

2. Dispositif d'éclairage selon la revendication 1, dans lequel le premier élément électro-luminescent et le second élément électro-luminescent sont dotés chacun d'une puce de diode électro-luminescente (23c, 24c) et d'un matériau fluorescent (23d, 24d) pour convertir la longueur d'onde du faisceau de lumière émis par la puce de diode électro-luminescente.

3. Dispositif d'éclairage selon la revendication 1, dans lequel est prévue une plaque de circuits imprimés qui est dotée d'une pluralité des premiers éléments électro-luminescents (23) et d'une pluralité des seconds éléments électro-luminescents (24).
